Europäisches Patentamt

European Patent Office

Office européen des brevets

(11) Publication number: **0 045 957**

**A1**

(12) # EUROPEAN PATENT APPLICATION

(21) Application number: **81106202.5**

(22) Date of filing: **07.08.81**

(51) Int. Cl.³: **C 08 K 5/00**
**C 08 L 67/06**

(30) Priority: **09.08.80 JP 109475/80**

(43) Date of publication of application:
**17.02.82 Bulletin 82/7**

(84) Designated Contracting States:
**BE DE FR GB IT NL**

(71) Applicant: **KANEGAFUCHI KAGAKU KOGYO KABUSHIKI KAISHA**
**2-4 Nakanoshima 3-chome**
**Kita-ku Osaka(JP)**

(72) Inventor: **Fushiki, Yasuo**
**21-1-437 Ohatacho Takatsuki-shi**
**Osaka-fu(JP)**

(72) Inventor: **Abe, Masaharu**
**1-1-604 Oishihigashimachi 1-Chome**
**Nada-ku Kobe(JP)**

(72) Inventor: **Oizumi, Masayuki**
**2-34 Yoshidacho 1-Chome**
**Hyogo-ku Kobe(JP)**

(74) Representative: **Kinzebach, Werner, Dr.**
**Reitstötter J., Prof. Dr. Dr. Kinzebach W., Dr. P.O. Box**
**780 Bauerstrasse 22**
**D-8000 München 43(DE)**

(54) **Flame-retarded curable resins.**

(57) An effective amount of a lead compound is added as a stabilizer to curable resins containing halogenated flame retardants to improve the heat-resistant properties of various shaped products made from the resins.

EP 0 045 957 A1

-1-

## BACKGROUND THE INVENTION

This invention relates to flame-retarded curable resins for use in the production of electrical insulating materials and the like.

Flame-retarded resins are widely used for safety reasons in various fields such as electrical communication instruments, household electrical instruments and the like.

Curable resins typically represented by thermosetting resins are used for the production of cast products, laminates, adhesives and other products for electrical uses. It is well known that these curable resins may be flame-retarded by incorporating therein a chlorinated or brominated flame-retardant. Since these halogenated flame retardants tend to decompose upon heating, resins containing these flame retardants often generate, when processing at elevated temperatures, harmful decomposition products such as HCl or HBr which are not only harmful for the health of operators but also corrosive to the processing apparatus. Generation of hydrohalides also takes place when electrical components such as electrical laminates made of flame-retarded resins are exposed to high-temperature environments. In this case the decomposition products cause to deteriorate the electrical components in mechanical, electrical and other characteristics. This is particularly true when the flame retardant is a halogenated aliphatic or cycloaliphatic compound.

-2-

It is, therefore, an object of the present invention to provide flame-retarded curable resins free from the above-described disadvantages.

It is another object of the present invention to provide a method for improving the thermal stability of halogenated flame retardants present in cured resins without interfering their flame retarding properties.

Other objects and advantages of the present invention may be apparent as the description proceeds.

## DESCRIPTION OF THE INVENTION

According to the present invention, we have found that thermal decomposition of halogenated flame retardants present in flame-retarded curable resins may be prevented by incorporating an effective amount of a lead compound as a stabilizing agent into the resin. The resultant flame-retarded resin may be processed for producing various electrical materials and components at an elevated temperature without the generation of harmful decomposition products and the electrical materials and components made from the flame-retarded resin can withstand high-temperature environments without substantial deterioration of mechanical and electrical characteristics. The addition of lead compounds to the resin does not adversely affect the electrical and mechanical properties of the electrical materials made from the resin but sometimes leads to increase in the insulating properties. These findings are surprising because the flame retardance and thermal resistance have been believed to be incompatible.

According to the present invention, there is provided a flame retarded resin composition comprising a curable resin and a halogenated flame retardant. The improvement resides in said composition further comprising an effective amount of a lead compound as a stabilizing agent for the flame retardant.

The amount of lead compound to be incorporated into the resin varies depending upon the nature and proportion of particular flame retardants and generally lies from 0.1 to 20 % by weight in terms of elementary lead based on the total weight of the resin composition. Less than 10% is preferable.

Curable resins include not only thermosetting resins but also resins which cure upon irradiation of ionizing rays such as ultraviolet light, electron ray, and gamma ray. Examples thereof include unsaturated polyester resins, diallyl phthalate resins, vinyl ester resins, phenol resins, xylene resins, epoxy resins, melamine resins, urea resins and the like.

Halogenated flame retardants include both non-reactive and reactive types. Examples of the non-reactive type include halogenated aliphatic and cycloaliphatic hydrocarbons such as chlorinated paraffin, tetrabromethane, tetrabromobutane, and hexabromocyclododecane; halogenated aryl compounds such as chlorinated diphenyl, chlorinated diphenyl ether, brominated diphenyl, brominated diphenyl ether, brominated phenol, hexabromobenzene and pentabromotoluene; Dechlorane and Dechlorane Plus Series sold by Hooker Chemical Corp.

Examples of the reactive type include polyols such as dibromoneopentyl glycol, tetrabromobisphenol A and its derivatives; polycarboxylic acids such as chlorinated endo acids, tetrachlorophthalic anhydride, and tetrabromophthalic anhydride; and cross-linking monomers such as chlorostyrene, bromostyrene, tribromophenyl acrylate and tribromophenyl methacrylate. They are used as reaction components for producing flame-retarded unsaturated polyester resins. Tetrabromobisphenol A may also be used for producing epoxy and phenol resins. Halogenated polycarboxylic acids of the above-mentioned type may be used as hardeners for epoxy resins. Alternatively, flame-retarded unsaturated polyester resins may be synthesized, for example, by the post-bromination of halogen-free unsaturated polyesters comprising tetrahydrophthalic acid. See, Japanese Patent Publication Nos. 8993/1971 and 84838/1972.

Various halogenated flame retardants and their uses in the production of flame-retarded resins are well-known in the art. Generally, the flame retardance of halogenated flame retardants are directly proportional to their halogen contents. Bromo compounds are more effective than chloro compounds when compared at the same levels of halogen contents. Also the flame retardances generally become greater in the order of aromatic, cycloaliphatic and aliphatic flame retardants. However, the thermal stabilities thereof are decreasing in the reverse order and bromo compounds are less stable than chloro compound. It is for this reason that aromatic flame retardants have been mostly used in the fields where high thermal stabilities and heat resistances are required. The present invention enables the use of cycloaliphatic and aliphatic flame retardants in such fields by stabilizing these flame retardants with lead compounds.

Examples of usable lead compounds include inorganic lead salts such as lead chlorides, lead sulfates, lead phosphites, lead nitrates, lead carbonates, lead silicates and the like; oxides and hydroxides; organic salts such as lead acetates, lead salicylates, lead stearates and lead naphthenates; and organic lead compounds such as tetraethyl lead. Basic lead salts such as tribasic lead sulfate, basic lead sulfite, dibasic lead phosphite, dibasic lead phthalate, tribasic lead maleate, basic lead silicate, basic lead carbonate, and dibasic lead stearate are preferable. They are effective in amounts generally from 0.1 to 20% by weight in terms of elementary lead based on the total weight of the resin composition.

Experiments have shown that a remarkable improvement in the thermal stability and heat resistance may be obtained by incorporating a lead compound preferably a basic lead salt into unsaturated polyester resins containing halogenated flame retardants. Improvements in heat resistance may be found in various items such as mechanical strength, electrical insulation, color change, distortion, volatile matters and the like. Unsaturated polyesters may be of thermosetting types or those which cure by the irradiation of an ionizing ray.

Lead compounds such as basic lead salts have been hitherto used as stabilizers for homopolymers and copolymers of vinyl chloride. However, it has not been known to our best knowledge to use them for improving the heat resistance of flame-retarded resins.

The flame-retarded resins of the present invention may contain fillers and other additives known in the art depending upon their intended uses. For example, phenols, bisphenols, epoxy compounds, and acid-binding fillers such as aluminum hydroxide, magnesium hydroxide and calcium carbonate may be added to improve the thermal stability. Conventional antioxidants and UV absorbents may also be added. The halogenated flame retardants may be used in combination with other flame retardants and fire retardants such as organic phosphorus compounds, halogen-containing organic phosphorus compounds, inorganic phosphorus compounds, antimony trioxide and the like.

The flame-retarded curable resins of the present invention may be prepared by any conventional method known in the art except an amount of a lead compound disclosed

- 7 -

herein is incorporated into the resin. The lead compound must be uniformly dispersed in the resin to exhibit its effect to the fullest extent. To this end, the lead compounds may be coated with higher fatty acids or silane compounds to facilitate the uniform dispersion and are preferably divided into fine particles, for example, of 0.1 to 7 μm particle size. The resultant resins may be used, for example, for impregnating fibrous substrates to be used in the production of electrical laminates.

The flame-retarded curable resins of the present invention may be used as materials for the production of various shaped articles such as automobile parts, electrical and electronic parts, and building materials. The resins are especially suitable for electrical and electronic uses such as laminated insulation boards, printed circuit wiring boards and other shaped articles which require high flame retardance and heat resistance as well as high electrical characteristics such as those required by UL standards.

Examples of shaped articles include panels, pipes, bars and other shaped structural materials made from the resins of this invention by conventional shaping techniques such as molding, casting and the like; electrical parts such as plugs and connectors; fire-proof building materials containing large amounts of fillers such as calcium carbonate and asbestos; and fiber reinforced shaped articles such as fiber reinforced pipes. Particularly important uses are electrical insulation laminates and metal clad laminates for the production of printed circuit wiring boards. They are prepared by impregnating a suitable substrate such as glass cloths, glass nonwoven fabrics, kraft paper, linter paper, cotton paper, asbestos cloths, synthetic fiber cloths or nonwoven fabrics with the curable resin of the present invention, laminating a plurality of impregnated substrates into a unitary member, and curing the same. Thus, flame-retarded electrical insulation laminates and metal clad laminates made of, for example, unsaturated polyester resins may be produced. The metal clad laminates preferably have an adhesive layer of 5 to 150 μm thick at the interface between the cladding metal foil and the laminate for firmly bonding the metal foil such as electrolytic copper foil onto the surface of laminate. Any conventional adhesive may be used for this purpose. Examples of suitable adhesives include epoxy adhesives, polyvinyl butyral-phenol adhesives, nitrile rubber-phenol adhesives and the like. These adhesives may or may not contain flame retardants.

The resultant unclad and clad laminates have the following advantages:

1) A high self-extinguishability such as a grade according to UL-94 may be easily attained even when non-self-extinguishable cellulosic papers are used as reinforcing substrates. Experiments have shown that the grade V0 or V1 may be attained when the paper reinforced laminate has a bromine content from 7 to 15% by weight. Paper substrates to be impregnated with flame-retarded unsaturated polyester resins are preferably pretreated with a methylol compound such as N-methylolacrylamide and trimethylolmelamine to improve moisture-proof-ness. This pretreatment does not adversely affect the self-extinguishability of the resultant laminates.

2) Excellent flame-retardance may be attained in the testing items of high voltage arc ignition test, high current arc ignition test and hot wire ignition test according to UL-746A. Anti-arc and anti-tracking characteristics are also found to be excellent.

The above advantages 1) and 2) may be attained to certain extent by using aromatic flame retardants without lead stabilizers. However, the present invention enables to use aliphatic and cycloaliphatic flame retardants in combination with the lead stabilyzer with the reduction in quantities of expensive flame retardants.

3) Decrease in flexural strength and dielectric strength upon long-term heating as determined by UL-746B may be minimized. Heretofore, aliphatic and cycloaliphatic halogenated flame retardants have not been able to use because they tend to deteriorate these properties. The use of lead stabilizers according to the present invention enables to use aliphatic and cycloaliphatic flame-retardants in this field.

4) Decrease in peel strength of metal clad laminates upon long term heating as determined by UL-796 may be minimized. The decrease in peel strength is believed to occur by the generation of hydrogen halides which attack the adhesive layer from the halogenated flame retardant. The use of lead compounds according to the present invention may effectively inhibit the thermal decomposition of halogenated flame retardants and thus retains most of the original peel strength. The decrease in peel strength may be further prevented by incorporating a lead compound into the adhesive layer. This may be performed by mixing the lead compound in an amount corresponding to 0.1 to 30% by weight, preferably from 0.2 to 15% by weight as elementary lead based on the total weight of the adhesive. Excessive amounts may adversely affect the peel strength and, therefore, should be avoided.

The following examples are given by way of illustration and not by way of limitation.

All parts and percents therein are by weight.

EXAMPLE 1

67 parts of a commercial unsaturated polyester resin containing brominated cycloaliphatic flame retardant (FMS 583 sold by Nippon Yupika Co., Ltd.), 25 parts of a commercial halogen-free unsaturated polyester resin (POLYMAL 6320 F sold by Takeda Chemical Industries, Ltd.), 8 parts of styrene monomer, 1 part of PERHEXA 3M (Nippon Oil and Fats Co., Ltd.) and 7 parts of TRIBASE (tribasic lead sulfate, TL-7000 sold by Sakai Chemical Industry Co., Ltd.) were thoroughly mixed to give a flame-retarded unsaturated polyester resin composition.

A kraft paper of 285 μm thick which had been preimpregnated with a mixture of melamine resin (S-305 sold by Nippon Carbide Industries Co., Ltd.) and oleyl monoglyceride (RIKEMAL OL-100) was continuously impregnated with the above resin composition on one side by means of the curtain-flow method. Five sheets of the impregnated paper were then laminated together and the assembly was sandwiched between a copper foil of 35 μm thick and a cellophane film of 35 μm thick. The copper foil was given on one side facing the laminate an adhesive coating consisting of 70 parts of a commercial epoxy resin (EPIKOTE 828, Shell Chemical) and 30 parts of a commercial polyamide hardner (VERSAMID 125, Henkel Japan). The resultant sandwich was then continuously passed through a tunnel oven at 110℃ requiring for 30 minutes. After cutting into a suitable size, the clad laminate was heated at 100℃ for 10 hours and at 160℃ for ten minutes to obtain fully cured copper clad laminate of 1.6 mm thick. The cladding copper foil was then completely removed by etching. The resultant insulation laminate was tested on the flame retardance by the method of UL 94. The heat resistance was evaluated by determining the retention rate of peel strength after heating the laminate at 150℃ for 10 days and the retention rate of flexural strength after heating at 180℃ for 5 days, respectively.

The results are shown in Table 1.

EXAMPLE 2

The process of Example 1 was repeated that the copper cladding foil was given on one side facing the laminated an adhesive coating consisting of 70 parts of EPIKOTE 828, 30 parts of VERSAMID and 5 parts of TRIBASE. The properties of the resulting copper clad laminate of 1.6 mm thick are shown in Table 1.

EXAMPLE 3

57 parts of FMS 583, 35 parts of POLYMAL 6320 F, 8 parts of styrene monomer, 1 part of PERHEXA 3M, 5 parts of antimony trioxide (sold by Nippon Seiko Co., Ltd.), and 7 parts of TRIBASE were thoroughly mixed to give a flame-retarded unsaturated polyester resin composition.

The process of Example 2 was repeated except that the above resin composition was used in the impregnation step.

The properties of the resultant copper clad laminate of 1.6 mm thick are shown in Table 1.

EXAMPLE 4

55 parts of FMS 583, 35 parts of POLYMAL 6320 F, 10 parts of styrene monomer, 1 part of PERHEXA 3M, 5 parts of antimony trioxide, 7 parts of TRIBASE, and 5 parts of aluminum hydroxide (HIGILITE H-42M, Showa Light Metal Co., Ltd.) were thoroughly mixed to give a flame-retarded unsaturated polyester composition.

The process of Example 2 was repeated except that the above resin composition was used in the impregnation step.

The properties of the resultant copper clad laminate of 1.6 mm thick are shown in Table 1.

EXAMPLE 5

The process of Example 3 was repeated except that tribasic lead maleate was replaced for TRIBASE. The properties of the resultant copper clad laminate are shown in Table 1.

COMPARATIVE EXAMPLE 1

The process of Example 1 was repeated except that the resin composition consisted of 67 parts of FMS 583, 25 parts of POLYMAL 6320 F, 8 parts of styrene monomer, and 1 part of PERHEXA 3M and did not contain TRIBASE. The properties of the resultant copper clad laminate are shown in Table 1.

Table 1

| Example No. | Flame Retardance (UL Grade) | Heat Resistance | | | Br Content in Insulation Laminate |
|---|---|---|---|---|---|
| | | Retention Rate, Peel Strength (150°C X 10 days) | Retention Rate, Flexural Strength (180°C X 5 days) | Color Change (150°C X 10 days) | |
| 1 | $V_1$ | 35% | 74% | ○ | 9.0% |
| 2 | $V_1$ | 63% | 72% | ○ | 9.0% |
| 3 | $V_0$ | 82% | 80% | ○ | 7.7% |
| 4 | $V_0$ | 88% | 79% | ○ | 7.4% |
| 5 | $V_0$ | 70% | 69% | ○ | 7.7% |
| Comparative 1 | $V_1$ | 17% | 63% | ✕ | 9.0% |

Note:

  1)  Peel strength was determined by JIS C-6481

  2)  Flexural strength was determined by UL 746A

  3)  Color change degrees are as follows:

      ◎  Very slight

      ○  Slightly foxed

      △  Brown

      ✕  Black

EXAMPLE 6

     100 parts of POLYMAL 6305 (unsaturated polyester resin sold by Takeda Chemical Industries, Ltd.), 30 parts of commercial non-reactive brominated aromatic flame-retardant SR-900 (Dai-Ichi Kogyo Seiyaku Co., Ltd.), 5 parts of antimony trioxide, and 7 parts of TRIBASE were thoroughly mixed.

     The process of Example 2 was repeated except that the above resin composition was used in the impregnation step.

     The properties of the resultant copper clad laminate of 1.6 mm thick are shown in Table 2.

COMPARATIVE EXAMPLE 2

     The process of Example 6 was repeated except that the resin composition did not contain TRIBASE.

     The properties of the resultant copper clad laminate are shown in Table 2.

EXAMPLE 7

     50 parts of EPIKOTE 1001 (bisphenol A epoxy resin sold by Shell Chemical), 50 parts of DER 542 (brominated bisphenol A epoxy resin sold by Dow Chemical), 4 parts of dicyandiamide, 0.5 parts of benzyldimethylamine, and 7 parts of TRIBASE were thoroughly mixed and dissolved in a solvent to give a varnish. A kraft paper of 285 μm thick was impregnated with this varnish and then dried to give a prepreg having a resin content of about 50%. 8 plies of the prepregs were stacked and an electrolytic copper foil of 35 μm thick was super-imposed onto one side of the stack. Then the resulting assembly was pressed at 170°C at 50 kg/cm$^2$ for 60 minutes. The properties of the resultant copper clad laminate of 1.6 mm thick are shown in Table 2.

COMPARATIVE EXAMPLE 3

The process of Example 7 was repeated except that the resin varnish did not contain TRIBASE.

The properties of the resultant copper clad laminate are shown in Table 2.

Table 2

| Example No. | Flame Retardance (UL Grade) | Heat Resistance | | | Br Content in Insulation Laminate |
|---|---|---|---|---|---|
| | | Retention Rate, Peel Strength (150℃ X 10 days) | Retention Rate, Flexural Strength (180℃ X 5 days) | Color Change (150℃ X 10 days) | |
| 6 | V$_1$ | 92% | 83% | ◎ | 8.3% |
| Comparative 2 | V$_1$ | 68% | 77% | ○ | 8.3% |
| 7 | V$_0$ | 90% | 79% | ◎ | 11.5% |
| Comparative 3 | V$_0$ | 75% | 71% | ◎ − ○ | 11.5% |

- 17 -

- 18 -

The above has been offered for illustrative purposes only, and it is not for the purpose of limiting the scope of this invention, which is defined in the claims below.

WE CLAIM:

1. Flame-retarded curable resin composition containing a halogenated flame retardant characterized in that said composition contains an effective amount of a lead compound as a stabilizer for said halogenated flame retardant.

2. Composition of claim 1 characterized in that said lead compound is a basic lead salt with an inorganic or organic acid.

3. Composition of claim 1 characterized in that said resin composition contains said lead compound in an amount from 0,1 to 20 % by weight as elementary lead based on the total weight of the resin composition.

4. Composition of claim 3 characterized in that said amount is less than 10 % by weight.

5. Composition of claim 1 characterized in that said halogenated flame retardant is selected from the group consisting of chlorinated or brominated aliphatic, cycloaliphatic and flame retardants.

6. Composition of claim 1 characterized in that said curable resin is a thermosetting resin.

7. Composition of claim 1 characterized in that said curable resin is selected from the group consisting of unsaturated polyester resin, diallyl phthalate resin, vinyl ester resin, and epoxy resin.

8. A shaped article made of the resin compositions according to one of the preceeding claims.

9. A shaped article according to claim 8 made of a fully cured resin for electrical uses.

10. The shaped article of claim 9 in the form of an electrical reinforced resin laminate.

11. The shaped article of claim 10 characterized in that it further comprises a cladding metal foil bonded to at least one side of said laminate.

12. The shaped article of claim 10 or 11 characterized in that the resin is reinforced with cellulosic paper.

13. The shaped article of claim 11 characterized in that an adhesive layer is present at the interface between said cladding metal foil and said laminate.

14. The shaped article of claim 13 characterized in that said adhesive layer contains a lead compound.

European Patent Office

**EUROPEAN SEARCH REPORT**

## DOCUMENTS CONSIDERED TO BE RELEVANT

| Category | Citation of document with indication, where appropriate, of relevant passages | Relevant to claim |
|---|---|---|
| X | <u>US - A - 4 033 926</u> (A. ANDERSON)<br>* Claim 1, column 7, lines 28-50 *<br>-- | 1-14 |
| X | <u>GB - A - 1 222 738</u> (BERK LIMITED)<br>* Claims *<br>-- | 1-14 |
| | <u>US - A - 3 677 942</u> (M. FEINER et al.)<br>* Claims *<br>-- | 1,2 |
| | <u>US - A - 3 860 676</u> (J. KRACKELER et al.)<br>* Claim 1 *<br>---- | 1,2 |

### CLASSIFICATION OF THE APPLICATION (Int. Cl.³)

C 08 K 5/00
C 08 L 67/06

### TECHNICAL FIELDS SEARCHED (Int. Cl.³)

C 08 K 3/00
5/00
C 08 L 63/00
67/06

### CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 19-11-1981 | HOFFMANN |

EPO Form 1503.1 06.78